(19) Europäisches Patentamt / European Patent Office / Office européen des brevets

(11) **EP 1 498 741 B1**

(12) **EUROPEAN PATENT SPECIFICATION**

(45) Date of publication and mention
of the grant of the patent:
**15.08.2012 Bulletin 2012/33**

(51) Int Cl.:
***G01R 22/10*** *(2006.01)*   ***G01R 35/04*** *(2006.01)*

(21) Application number: **04468013.0**

(22) Date of filing: **15.07.2004**

(54) **Watthour meter with integrated self-testing**

Wattstundenzähler mit integriertem Selbsttest

Wattheuremètre avec autotest intégré

(84) Designated Contracting States:
**DE GB**

(30) Priority: **15.07.2003 SI 200300180**

(43) Date of publication of application:
**19.01.2005 Bulletin 2005/03**

(73) Proprietor: **Iskraemeco, Merjenje in Upravljanje Energije, D.D.**
**4000 Kranj (SI)**

(72) Inventors:
• **Rozman, Miro**
**4248 Lesce (SI)**

• **Kosmac, Milan**
**4274 Zirovnica (SI)**

(74) Representative: **Gros, Mladen**
**Patentna pisarna d.o.o.**
**Copova 14**
**P.O. Box 1725**
**1001 Ljubljana (SI)**

(56) References cited:
**EP-A- 0 644 431   EP-A- 0 871 040**
**US-A- 5 128 611   US-A- 6 078 870**

**Description**

The invention concerns a watthour meter, which is provided with a voltage sensor in the form of a voltage divider and with an inductive current sensor sensing a current flowing through a load, the output signals of said sensors being amplified and digitized, and with a digital signal processor, which according to the invention generates signals to control a switching matrix so that, in order to perform a self-testing of the watthour-meter operation, an electric work Wl on the load and a testing electric work Wt done on the resistors of said voltage divider are measured alternatingly.

A watthour meter has an operating life usually exceeding twenty years and it must operate reliably and precisely through this whole period. The testing of its correct operation is performed in a laboratory. The transport of the watthour-meter to the laboratory is expensive and may even prove unnecessary if the watthour meter operates correctly. These expenses could be avoided if the watthour meter could test itself when operating, since only those watthour meters, at which a maloperation or a failure was ascertained by means of the self-testing, would be tested in the laboratory.

In the patent US 5.128.611 there is disclosed an electronic electricity meter comprising a current sensor which consists of a linear reactance coil. The voltage induced herein is fed through an analogue integrator generating a current-proportional voltage. The integrator characteristic time constant is subject to fluctuations caused by temperature changes and aging. By applying a reference direct voltage to the integrator input a self-calibration, initiated by the microcomputer, is performed.

There has been known (EP 0 871 040 A2) a calibration method for an electronic electricity meter including an AD converter. An analogue input signal is fed to the converter input through resistors connected in parallel and one of them being switched on and off. The ratio of the on and off periods is chosen based on external comparison of the input and output values so as to calibrate the AD converter.

Further, also an electricity meter with multiplexers for monitoring measurement channels, wherefore an extensive self monitoring is performed by means of auxiliary signals, has been known (US 6,078,870).

There is also known an electric watthour meter employing automatic and manually initiated test functions for testing the operation of the processor and and other critical circuits in the meter (EP 0 644 431 A1).

Consequently, the technical problem to be solved by the present invention is to furnish a watthour meter of said kind in such a way that it will be able to test the operation of all its elements including voltage sensor and the current sensor by itself.

According to the invention the technical problem is solved by a watthour meter as defined in claim 1. The features of further embodiments of the invention are specified in dependent claims.

The invention will now be explained in more detail by way of the description of embodiments and with reference to the accompanying drawing representing in:

Fig. 1 the watthour meter of the invention and
Fig. 2a and b graphs representing the time dependence of the electric work in two circuit arrengements during the watthour-meter self-testing.

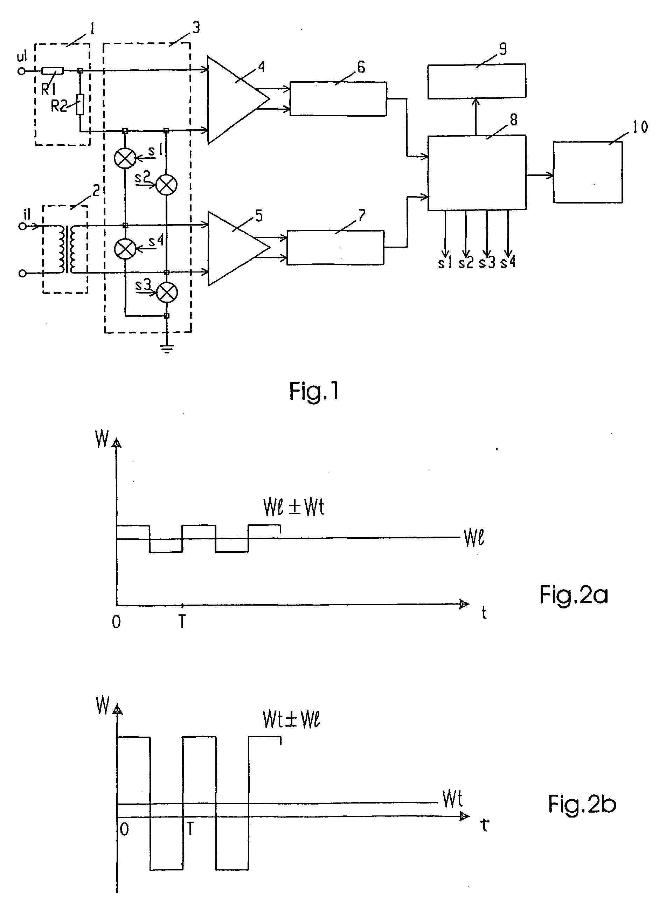

A watthour meter is provided with a voltage sensor 1 sensing the mains voltage ul that is *i.e.* the voltage across a load, and with an inductive current sensor 2 sensing a current il flowing through the load. The output signals of said sensors 1, 2 are amplified in an amplifier 4 and 5, respectively, and then digitized in a $\Sigma$-$\Delta$ analog-to-digital converter 6 and 7, respectively. Their output signals are processed in a digital signal processor 8 (Fig. 1). The processing of the measuring signals in the watthour meter is performed in any known way, for example according to the technical teaching in the patent application SI 200200216 (EP 1 378 756 A2) by the present applicant.

The voltage sensor 1 is made as a voltage divider consisting of a first resistor R1 and a second resistor R2.

The sensor 2 sensing the current flowing through the load is preferably an inductive current sensor, however, if a different current sensor is used, it is furnished with an added coil.

A switching matrix 3 assembled of four controlled switches s1, s2, s3 and s4 is connected to the output terminals of the voltage sensor 1 and of the current sensor 2.

The first controlled switch s1 is connected between the second output terminal of the voltage sensor 1 and the first output terminal of the current sensor 2. The second output terminal of the voltage sensor 1 is here specified as follows: in the watthour meter performing only the measurent of the electric work Wl done on the load without performing also the self-testing of the watthour meter, the second output terminal of the voltage sensor 1 is mass-connected; this can be achieved by closing the controlled switches s2 and s3.

The second controlled switch s2 is connected between the second output terminal of the voltage sensor 1 and the second output terminal of the current sensor 2. The third controlled switch s3 is connected between the second output terminal of the current sensor 2 and the mass, and the fourth controlled switch s4 is connected between the first output terminal of the current sensor 2 and the mass.

The electric work Wl done on the load and a testing electric work Wt done on the first and second resistor R1 and R2, respectively, of said voltage divider in the voltage sensor 1 are measured in order to perform the self-testing of the watthour meter when it is in operation. The testing electric work Wt results from an excitation by means of a test signal, which is known, and the response to this signal is known as well.

To measure the electric work Wl done on the load, the controlling output signals of the digital signal processor 8 close the first controlled switch s1 and the third controlled switch s3 in their first half-period T/2 and close the second controlled switch s2 and the fourth controlled switch s4 in their second half-period T/2. When the first controlled switch s1 and the third controlled switch s3 are closed, across a secondary coil of the current sensor 2, there is induced an additional voltage which results from a current dictated by the mains voltage ul across the resistor chain R1+R2 of the voltage divider in the voltage sensor 1.

To measure the testing electric work Wt done on the resistors R1, R2 of the voltage divider, the digital signal processor 8 reverses the polarity of the test signals synchronously with said switching of the four controlled switches s1, s2, s3, s4.

The electric works Wl and Wt are specified as:

$$Wl = \frac{R1}{R2} * ul * il * K \,, \qquad (1)$$

$$Wt = \frac{R1}{R2} * ul * \frac{ul}{R1+R2} * K \,, \qquad (2)$$

where K is a watthour-meter constant. Its value determines the precision of the watthour meter and this value is tested in the self-testing procedure.

Of course, it is supposed that the mains voltage ul is equal in all network and hence known. Thus in the equations (1) and (2) il and K are unknown quantities. The digital signal processor 8 namely calculates the electric work Wl done on the load and the testing electric work Wt done on the resistors R1, R2 of the voltage divider in the voltage sensor 1 as it is also graphically shown in Figs. 2a and 2b, on the basis of said measurements during self-testing of the watt-hour meter from the following equations

$$Wl = \frac{1}{2N} \sum_{i=1}^{N} (Wl_i + (-1)^i Wt_i) \,, \qquad (3)$$

$$Wt = \frac{1}{2N} \sum_{i=1}^{N} (Wt_i + (-1)^i Wl_i) \,. \qquad (4)$$

In the equations (3) and (4), 2N represents the number of half-periods; an individual addend is related to the $i^{th}$ half-period.

If the electric work Wl done on the load varies within the measuring period T, the measurement is performed until the current value of said electric work Wl equals its value at the beginning of the measurement.

A deviation of the established value of the constant K of the watthour meter from a predetermined value indicates a failure of the watthour meter or an unprecise metering. This is either signalized in the display 9 on the watthour meter front plate, thus warning reader of the meter count, or it is communicated to a control station by means of a modem 10.

The testing of the watthour meter of the invention proceeds automatically on the metering position and the result may be noticed each time when reading the watthour meter or remotely at any time.

**Claims**

1. Watthour meter, comprising a voltage sensor (1) in the form of a voltage divider consisting of a first resistor (R1) and a second resistor (R2), an inductive current sensor (2) sensing a current flowing through a load, means for amplifying and digitizing the output signals of said sensors (1, 2), and a digital signal processor (8),
**characterized in that**, in order to perform a self-testing of the watthour meter, the watth our meter further comprises

- a first controlled switch (s1), connected between a second output terminal of the voltage sensor (1) and a first output terminal of the current sensor (2), the second output terminal of the voltage sensor (1) being mass-connected when only the electric work WI done on the load is measured without performing the watthour-meter self-testing, and
- a second controlled switch (s2) connected between the second output terminal of the voltage sensor (1) and a second output terminal of the current sensor (2), and
- a third controlled switch (s3) connected between the second output terminal of the current sensor (2) and the mass, and
- a fourth controlled switch (s4) connected between the first output terminal of the current sensor (2) and the mass,

the four controlled switches being controlled by output signals of the digital signal processor (8) the digital processor (8) being configured for carrying out the following steps:

- closing only the first controlled switch (s1) and the third controlled switch (s3) in the first half-period of the out put signals and only the second controlled switch (s2) and the fourth controlled switch (s4) in the second half-period of the output signals for determining the electric work wl done on the load,
- reversing the polarity of known test signals synchronously with said switching of the four controlled switches (s1, s2, s3, s4) for determining a testing electric work Wt done on the resistors (R1, R2) of the voltage divider of the voltage sensor (1), the testing electric work Wt resulting from the excitation by means of the test signals, and
- calculating a watthour-meter constant K by means of the determined electric work Wl done on the load and of the determined testing electric work Wt.

2. Watthour meter as recited in claim 1, **characterized in that** in the case that the electric work WI done on the load varies within the measuring period, the watthour meter is configured for performing the measurement until a current value of said electric work Wl equals its value at the beginning of the measurement.

3. Watthour meter as recited in any of the previous claims, **characterized in that** an output of the digital signal processor (8) is connected to a display (9).

4. Watthour meter as recited in claim 1, **characterized in that** an output of the digital signal processor (8) is connected to a modem (10).


**Patentansprüche**

1. Wattstundenzähler, der einen Spannungssensor (1) in Form eines aus einem ersten Widerstand (R1) und einem zweiten Widerstand (R2) bestehenden Spannungsteilers, einen induktiven Stromsensor (2), der einen durch eine Last fliessenden Strom abtastet, Mittel zum Verstärken und Digitalisieren der Ausgangssignale der genannten Sensoren (1, 2) und einen digitalen Signalprozessor (8) umfasst,
**dadurch gekennzeichnet, daß** der Wattstundenzähler zum Durchführen des Selbstprüfens des Wattstundenzählers weiterhin

- einen zwischen einer zweiten Ausgangsklemme des Spannungssensors (1) und einer ersten Ausgangsklemme des Stromsensors (2) geschalteten ersten gesteuerten Schalter (s1), wobei die zweite Ausgangsklemme des Spannungssensors (1), als nur die an der Last geleistete elektrische Arbeit Wl ohne Durchführung des Selbstprüfens des Wattstundenzählers gemessen wird, mit Masse vebunden wird, und
- einen zwischen der zweiten Ausgangsklemme des Spannungssensors (1) und einer zweiten Ausgangsklemme des Stromsensors (2) geschalteten zweiten gesteuerten Schalter (s2), und
- einen zwischen der zweiten Ausgangsklemme des Stromsensors (2) und der Masse geschalteten dritten gesteuerten Schalter (s3), und
- einen zwischen der ersten Ausgangsklemme des Stromsensors (2) und der Masse geschalteten vierten gesteuerten Schalter (s4),

wobei die vier gesteuerten Schalter durch Ausgangssignale des digitalen Signalprozessors (8) gesteuert werden, wobei der digitale Signalprozessor (8) zum Ausführen folgender Schritte konfiguriert wird:

- das Schliessen nur des ersten gesteuerten Schalters (s1) und des dritten gesteuerten Schalters (s3) in der ersten Halbperiode des Ausgangssignals und nur des zweiten gesteuerten Schalters (s2) und des vierten gesteuerten Schalters (s4) in der zweiten Halbperiode des Ausgangssignals zum Bestimmen der an der Last geleisteten elektrischen Arbeit Wl,
- das Umkehren der Polarität bekannter Prüfsignale synchron zum genannten Schalten der vier gesteuerten Schalter (s1, s2, s3, s4) zum Bestimmen der an den Widerständen (R1, R2) des Spannungsteilers des Spannungssensors (1) geleisteten elektrischen Prüfarbeit Wt, wobei die elektrische Prüfarbeit Wt von der Erregung durch die Testsignale herrührt, und
- das Ausrechnen einer Konstante K des Wattstundenzählers durch die festgestellte an der Last geleistete elektrische Arbeit Wl und die festgestellte elektrische Prüfarbeit Wt,

umfasst.

2. Wattstundenzähler nach Anspruch 1, **dadurch gekennzeichnet, daß** der Wattstundenzähler im Falle der sich innerhalb der Messperiode ändernden an der Last geleisteten elektrischen Arbeit WI zum Ausüben des Messens konfiguriert wird, bis ein momentaner Wert der genannten elektrischen Arbeit WI ihrem Wert am Messbeginn gleicht.

3. Wattstundenzähler nach einem der vorangehenden Ansprüche, **dadurch gekennzeichnet, daß** ein Ausgang des digitalen Signalprozessors (8) an ein Datensichtgerät (9) angeschlossen ist.

4. Wattstundenzähler nach Anspruch 1, **dadurch gekennzeichnet, daß** ein Ausgang des digitalen Signalprozessors (8) an einen Modem (10) angeschlossen ist.

**Revendications**

1. Watt-heuremètre, comprenant un détecteur de tension (1) prenant la forme d'un diviseur de tension constitué par une première résistance (R1) et une deuxième résistance (R2), un détecteur de courant inductif (2) détectant un courant circulant dans une charge, un moyen pour amplifier et numériser les signaux de sortie desdits détecteurs (1, 2) et un processeur de signaux numérique (8),
**caractérisé en ce que**, afin de réaliser un autotest du watt-heuremètre, le watt-heuremètre comprend en outre :

- un premier commutateur commandé (s1), monté entre une deuxième borne de sortie du détecteur de tension (1) et une première borne de sortie du détecteur de courant (2), la deuxième borne de sortie du détecteur de tension (1) étant mise à la masse si seul le travail électrique W1 s'exerçant sur la charge est mesure sans réaliser l'autotest du watt-heuremètre, et
- un deuxième commutateur commandé (s2) monté entre la deuxième borne de sortie du détecteur de tension (1) et une deuxième borne de sortie du détecteur de courant (2), et
- un troisième commutateur commandé (s3) monté entre la deuxième borne de sortie du détecteur de courant (2) et la masse, et
- un quatrième commutateur commandé (s4) monté entre la première borne de sortie du détecteur de courant (2) et la masse,

les quatre commutateurs commandés étant commandés par des signaux de sortie du processeur de signaux numérique (8),
le processeur numérique (8) étant conçu pour mettre en oeuvre les étapes consistant à :

- fermer uniquement le premier commutateur commandé (s1) et le troisième commutateur commandé (s3) au cours de la première demi-période des signaux de sortie et uniquement le deuxième commutateur commandé (s2) et le quatrième commutateur commandé (s4) au cours de la deuxième demi-période des signaux de sortie afin de déterminer le travail électrique W1 s'exerçant sur la charge,
- inverser la polarité de signaux de test connus en synchronisme avec ladite commutation des quatre commutateurs commandés (s1, s2, s3, s4) afin de déterminer un travail électrique de test Wt s'exerçant sur les résistances (R1, R2) du diviseur de tension du détecteur de tension (1), le travail électrique de test Wt découlant de l'excitation au moyen des signaux de test, et
- calculer une constante K du watt-heuremètre au moyen du travail électrique W1 s'exerçant sur la charge ainsi déterminé et du travail électrique de test Wt ainsi déterminé.

**2.** Watt-heuremètre selon la revendication 1, **caractérisé en ce que**, dans le cas où le travail électrique W1 s'exerçant sur la charge varie au sein de la période de mesure, le watt-heuremètre est conçu pour réaliser la mesure jusqu'à ce qu'une valeur actuelle dudit travail électrique N1 soit égale à sa valeur au début de la mesure.

**3.** Watt-heuremètre selon l'une quelconque des revendications précédentes, **caractérisé en ce qu'**une sortie du processeur de signaux numérique (8) est reliée à un affichage (9).

**4.** Watt-heuremètre selon la revendication 1, **caractérisé en ce qu'**une sortie du processeur de signaux numérique (8) est reliée à un modem (10).

Fig.1

Fig.2a

Fig.2b

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5128611 A
- EP 0871040 A2
- US 6078870 A
- EP 0644431 A1
- SI 200200216
- EP 1378756 A2